# EUROPEAN PATENT APPLICATION

(11) **EP 1 335 488 A2**
(43) Date of publication of application: **13.08.2003**
(21) Application number: 02257205.1
(22) Date of filing: 17.10.2002
(51) Int. Cl.: H03D 7/16

(54) **Frequency conversion circuit having phase noises lowered**

(30) Priority: 08.11.2001 JP 2001343802
(71) Applicant: Alps Electric Co., Ltd., Tokyo 145-8501 (JP)
(72) Inventor: Maruyama, Takashi, c/o Alps Electric Co., Ltd., Ota-ku, Tokyo (JP); MacPherson, Rod, c/o Alps Electric (UK) Limited, Wymbush, Milton Keynes MK8 8LW (GB)
(74) Representative: Kensett, John Hinton

(57) **Abstract**

A frequency conversion circuit includes a plurality of mixers (1, 4, 8) cascaded, and a plurality of local oscillators (2, 6, 10) provided in correspondence with the mixers each, which supply local oscillation signals to the mixers each.. The frequency conversion circuit further includes a plurality of PLL circuits (3, 7, 11) that control local oscillation frequencies of the local oscillators each in correspondence with the local oscillators each. In conjunction with this construction, the local oscillators are made to oscillate at intervals of step frequencies set to the PLL circuits each, and an order of magnitude of the local oscillation frequencies is made coincident with an order of magnitude of the step frequencies.

## Description

### BACKGROUND OF THE INVENTION

### 1. Field of the Invention

The present invention relates to a frequency conversion circuit for use in up line transmitters and so forth in a two-way system using the digital ground wave broadcasting or the like.

### 2. Description of the Related Art

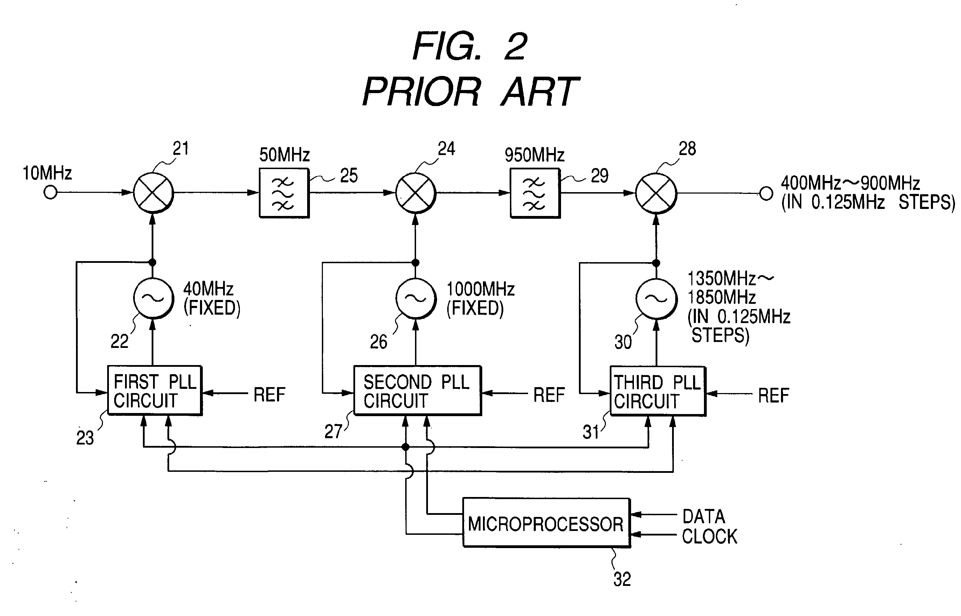

A conventional frequency conversion circuit will be explained based on Fig. 2. This frequency conversion circuit is configured with three stages. A mixer 21 at the first stage receives a signal of 10 MHz and a local oscillation signal from a first local oscillator 22. The input signal of 10 MHz is transmitted from a viewer. A first PLL circuit 23 controls the first local oscillator 22 to lock the oscillation frequency at 40 MHz constant. A first stage mixer 21 outputs a signal converted into 50 MHz.

A mixer 24 at the second stage is cascaded to the first stage mixer 21 through a bandpass filter 25. A second stage mixer 24 receives the signal converted into 50 MHz and a local oscillation signal from a second local oscillator 26. A second PLL circuit 27 controls the second local oscillator 26 to lock the oscillation frequency at 1000 MHz constant. The second stage mixer 24 outputs a signal converted into 950 MHz.

A final, third stage mixer 28 is cascaded to the second stage mixer 24 through a bandpass filter 29. The third stage mixer 28 receives the signal converted into 950 MHz and a local oscillation signal from a third local oscillator 30. A third PLL circuit 31 controls the third local oscillator 30 so as to generate frequencies covering from 1350 MHz to 1850 MHz spaced in 0.125 MHz steps. The third stage mixer 28 outputs signal frequencies covering from 400 MHz to 900 MHz. The frequency interval of the outputted signals is 0.125 MHz, being the step frequency of the third PLL circuit 28.

A microprocessor 32 controls the PLL circuits 23, 27, 31 each, and the signal frequencies outputted from the third stage mixer 28 are set in accordance with the data inputted to the microprocessor 32.

The above frequency conversion circuit outputs any of signal frequencies from 400 MHz to 900 MHz spaced at 0.125 MHz intervals; however, the narrow frequency interval will produce the phase noise, which presents a serious problem. The phase noise is determined by the relation between the local oscillation frequency and the step frequency of the PLL circuit, which is given by the logarithm of the ratio of the step frequency S against the local oscillation frequency F (= F/S). And, as the value increases, the phase noise increases. In the foregoing configuration, the frequency of the third local oscillator is the highest; moreover, the step frequency of the corresponding PLL circuit is the step frequency of the output signal. Thus, the above ratio becomes equal to 10800 (= 1350/0.125) even at the minimum value, which is sufficiently large to make the phase noise worse.

### SUMMARY OF THE INVENTION

Accordingly, an object of the invention is to reduce the phase noise in the frequency conversion circuit in which each stage is provided with a mixer, a local oscillator, and a PLL circuit.

In order to accomplish the object, the frequency conversion circuit of the invention includes a plurality of mixers cascaded, and a plurality of local oscillators provided in correspondence with the mixers each, which supply local oscillation signals to the mixers each. Further, the frequency conversion circuit is provided with a plurality of PLL circuits that control local oscillation frequencies of the local oscillators each in correspondence with the local oscillators each. In conjunction with this construction, the local oscillators are made to oscillate at intervals of step frequencies set to the PLL circuits each, and an order of magnitude of the local oscillation frequencies is made coincident with an order of magnitude of the step frequencies.

Further in the above construction, the local oscillator corresponding to a PLL circuit set to a minimum step frequency of the PLL circuits is made to oscillate within a predetermined frequency range.

Further in the above construction, an interval of the step frequencies of the PLL circuit corresponding to a first stage mixer is set to an interval of the minimum step frequency.

An embodiment of the present invention will now be described, by way of example only, with reference to the accompanying diagrammatic drawings, in which:
Fig. 1 is a block diagram illustrating the configuration of a frequency conversion circuit of the invention; and
Fig. 2 is a block diagram illustrating the configuration of a conventional frequency conversion circuit.

### DESCRIPTION OF THE PREFERRED EMBODIMENTS

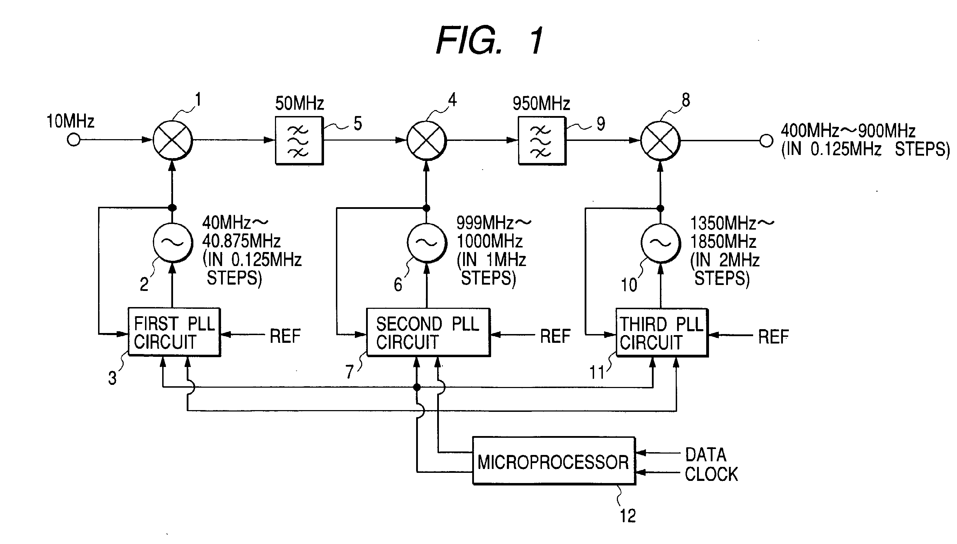

The frequency conversion circuit of the invention will be described with reference to Fig. 1 and Table 1. The frequency conversion circuit of the invention is configured with three stages. A first stage mixer 1 inputs a signal of 10 MHz with which a viewer responds to, and a local oscillation signal from a first local oscillator 2. A first PLL circuit 3 controls the first local oscillator 2 so as to oscillate frequencies covering from 40 MHz to 40.875 MHz spaced in 0.125 MHz steps. The first stage mixer 1 outputs any one of signals in which the input signal frequencies are converted into the signal frequencies of about 50 MHz spaced at 0.125 MHz intervals.

A second stage mixer 4 is cascaded to the first stage mixer 1 through a bandpass filter 5. The second stage mixer 4 inputs the signal converted into any one of frequencies 50 MHz through 50.875 MHz and a local oscillation signal from a second local oscillator 6. A second PLL circuit 7 controls the second local oscillator 6 so as to generate a frequency 999 MHz or 1000 MHz. The second stage mixer 4 outputs any one of signals in which the input signal frequencies are converted into the signal frequencies of about 950 MHz spaced at 0.125 MHz intervals.

A final, third stage mixer 8 is cascaded to the second stage mixer 4 through a bandpass filter 9. The third stage mixer 8 inputs the signal converted into 950 MHz and a local oscillation signal from a third local oscillator 10. A third PLL circuit 11 controls the third local oscillator 10 so as to oscillate frequencies covering from 1350 MHz to 1850 MHz spaced in 2 MHz steps. The third stage mixer 8 outputs signal frequencies converted into the frequency range from 400 MHz to 900 MHz. The frequency interval of the outputted signals is 0.125 MHz.

A microprocessor 12 controls the PLL circuits 3, 7, 11 each, and the signal frequencies outputted from the third stage mixer 8 are set in accordance with the data inputted to the microprocessor 2.

Next, with reference to Table 1 will be explained the relations of the oscillation frequency of the first local oscillator 2 (first local oscillation frequency OSC1), the oscillation frequency of the second local oscillator 6(second, local oscillation frequency OSC2), and the oscillation frequency of the third local oscillator 10 (third local oscillation frequency OSC3) against the signal frequency outputted from the third stage mixer 8 (output frequency OUT) .

**[Table 1]**

| OUT | OSC1 | OSC2 | OSC3 |
|---|---|---|---|
| 400.000 | 40.000 | 1000.000 | 1350.000 |
| 400.125 | 40.125 | | |
| . | . | ↓ | ↓ |
| . | . | | |
| . | . | | |
| 400.875 | 40.875 | | |
| 401.000 | 40.000 | 999.000 | |
| 401.125 | 40.125 | | |
| . | . | ↓ | |
| . | . | | |
| . | . | | |
| 401.875 | 40.875 | | |
| 402.000 | 40.000 | 1000.000 | 1352.000 |
| 402.125 | 40.125 | | |
| | | | |
| | | ↓ | ↓ |
| | | | |
| | | | |
| 899.875 | 40.875 | 1000.000 | 1850.000 |
| 900.000 | 40.000 | 999.000 | 1850.000 |
| 0.125 MHz steps | 0.125 MHz steps | 0.1.25-MHz steps | 2 MHz steps |

First, if the output frequency (OUT) is 400 MHz, the first local oscillation frequency (OSC1) through the third local oscillation frequency (OSC3) will be 40 MHz, 1000 MHz, 1350 MHz, respectively. As the output frequency (OUT) increases, the first local oscillation frequency (OSC1) increases at 0.125 MHz intervals. When the output frequency (OUT) is increased just by 1 MHz to reach 401 MHz, the first local oscillation frequency (OSC1) is reset to 40 MHz. At the same time, the second local oscillation frequency (OSC2) is decreased by 1 MHz and reset to 999 MHz.

In the same manner, until the output frequency (OUT) increases to 401.875 MHz, the first local oscillation frequency (OSC1) increases in 0.125 MHz steps. When the output frequency (OUT) is increased exactly to 402 MHz, the first local oscillation frequency (OSC1) is reset to 40 MHz, and also the second local oscillation frequency (OSC2) is reset to 1000 MHz. At the same time, the third local oscillation frequency (OSC3) is reset to 1352 MHz, higher by 2 MHz than the original.

In the same manner as above, every time the output frequency (OUT) increases by 1 MHz, the first local oscillation frequency (OSC1) is reset repeatedly, and the second local oscillation frequency (OSC2) is reset to 1000 MHz and 999 MHz alternately repeatedly. The third local oscillation frequency (OSC3) is increased in 2 MHz steps every time the output frequency (OUT) increases by 2 MHz.

According to the relation of the above local oscillation frequencies, the output frequency (OUT) is set to any one of the frequencies from 400 MHz through 900 MHz spaced in 0.125 MHz steps.

In this invention, the ratio of the oscillation frequency and the step frequency in the first local oscillator 2 is about 320 (= 40/0.125), the ratio of the oscillation frequency and the step frequency in the second local oscillator 6 is about 1000 (= 1000/1), and the ratio of the medium value of the oscillation frequency and the step frequency in the third local oscillator 10 is about 800 (= 1600/2); and the overall ratio is given by the sum of these ratios, which is 2120. This vale is equivalent to about 1/5 of the conventional. Accordingly, the phase noise is remarkably improved.

As described above, according to the invention, the frequency conversion circuit includes a plurality of mixers cascaded, and a plurality of local oscillators provided in correspondence with the mixers each, which supply local oscillation signals to the mixers each. Further the frequency conversion circuit is provided with a plurality of PLL circuits that control local oscillation frequencies of the local oscillators each are provided in correspondence with the local oscillators each. In conjunction with this construction, the local oscillators are made to oscillate at intervals of step frequencies set to the PLL circuits each, and the order of magnitude of the local oscillation frequencies is made coincident with the order of magnitude of the step frequencies, thereby reducing the phase noise.

Further, since the oscillator corresponding to a PLL circuit set to the minimum step frequency of the PLL circuits is made to oscillate within a predetermined frequency range. the final stage mixer is capable of outputting signals at the interval of the minimum step frequency.

Further, since the interval of the step frequencies of the PLL circuit corresponding to the first stage mixer is set to the interval of the minimum step frequency, the frequency of the signal outputted from the final stage mixer can be made higher than the frequency of the signal inputted to the first stage mixer.

## Claims

1. A frequency conversion circuit comprising a plurality of cascaded mixers, and a plurality of local oscillators, each of which supplies local oscillation signals to a respective mixer, wherein
a plurality of PLL circuits that control local oscillation frequencies of the local oscillators are provided, each corresponding to a respective local oscillator,
wherein the local oscillators are made to oscillate at intervals of step frequencies set to the respective PLL circuits, and
wherein an order of magnitude of the local oscillation frequencies is made coincident with an order of magnitude of the step frequencies.

2. A frequency conversion circuit according to Claim 1,
wherein the local oscillator corresponding to a PLL circuit set to a minimum step frequency of the PLL circuits is made to oscillate within a predetermined frequency range.

3. A frequency conversion circuit according to Claim 2,
wherein an interval of the step frequencies of the PLL circuit corresponding to the mixer of a first stage is set to an interval of the minimum step frequency.
